Europäisches Patentamt

European Patent Office

Office européen des brevets

(19)

(11) **EP 1 635 450 A1**

(12) **EUROPEAN PATENT APPLICATION**

(43) Date of publication:
**15.03.2006 Bulletin 2006/11**

(51) Int Cl.:
***H03D 1/18*** (2006.01)

(21) Application number: **05019999.1**

(22) Date of filing: **14.09.2005**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **14.09.2004 KR 2004073498**

(71) Applicant: **LG Electronics Inc.
Yongdungpo-gu
Seoul (KR)**

(72) Inventor: **Lee, Seung-Min**

**-ri Guseong-eup,
Yongin-si,
Gyeonggi-do (KR)**

(74) Representative: **von Hellfeld, Axel
Wuesthoff & Wuesthoff
Patent- und Rechtsanwälte
Schweigerstrasse 2
81541 München (DE)**

(54) **Signal demodulation circuit having operational amplifier with disable function**

(57)     The present invention relates to a scheme for simply implementing a demodulation circuit, which is a core circuit of a measuring instrument, using a lock-in detection method. The present invention provides a signal demodulation circuit includes an inverting amplifying circuit and a low pass filter circuit. The inverting amplifying circuit has an operational amplifier with a disable function. The low pass filter circuit is electrically connected to an output terminal of the inverting amplifying circuit to output a signal wave. Accordingly, the present invention provides a signal demodulation circuit, which has a simplified construction, thus reducing the size of the circuit, enabling a demodulation circuit to be implemented when a multi-channel signal is processed or when circuit space is limited, and greatly reducing production costs and power consumption.

Fig. 1

**Description**

BACKGROUND OF THE INVENTION

1. Field of the Invention

The present invention relates to a scheme for simply implementing a demodulation circuit, which is a core circuit of a measuring instrument, using a lock-in detection method.

2. Description of the Related Art

In general measurement, signal amplification using an amplifier depends on the noise characteristics of the amplifier. Most amplifiers have noise characteristics of 1/f in a low frequency band, so that it is difficult to separate a small signal. If a signal to be measured has intensity arbitrarily generated by a target, an amplifier having very low noise over an entire frequency band must be inevitably used. However, when a measuring user desires to apply an arbitrary signal and measure a reaction to the signal so as to measure physical properties, such as resistance, it is possible to measure very low noise if a lock-in amplification method is used. The lock-in amplification method is a method of applying a physical quantity having a specific frequency to a target object or system to be measured, converting a response physical quantity generated by the target into a voltage or current signal, and demodulating the voltage or current signal so as to precisely measure response characteristics for the specific variable of the target object or system to be measured. That is, since the lock-in amplification method measures the intensity of a response, the noise characteristics of a high frequency band of an amplification circuit become the noise level of measurement. This shows that measurement noise much lower than that of a simple amplification method, in which low frequency noise, increasing to 1/f, becomes the main noise level of measurement, can be realized.

The core part of a lock-in circuit includes an amplifier having a low noise factor in a modulation frequency band, a demodulation circuit, and a signal post-processing circuit, such as a low pass filter. Generally, the demodulation circuit employs an analog multiplying IC using a Gilbert cell called a multiplier and operates to multiply a modulation frequency signal by an amplified measurement target signal and to perform low-pass filtering on a signal obtained by the multiplication, or employs a switch circuit and operates to convert an amplified measurement target signal at an amplification gain of +1 or -1 and to perform low-pass filtering on a conversion result signal. If the analog multiplying IC is used, a demodulation circuit is simplified, but, generally, there is a disadvantage in that current consumption and cost are increased, and the size of the demodulation circuit is increased at the time of executing multi-channel signal processing, in which a great number of signals are processed at one time. The demodulation circuit having a switching IC and an amplification gain of +1 or -1 is advantageous in that the cost thereof is somewhat lower than that of the demodulation circuit employing the analog multiplying IC, but disadvantageous in that the size of the demodulation circuit is also increased at the time of executing multi-channel processing because a separate circuit must be used.

SUMMARY OF THE INVENTION

Accordingly, the present invention has been made keeping in mind the above problems occurring in the prior art, and an object of the present invention is to provide a signal demodulation circuit, which is simply constructed using an operational amplifier with a disable function, in an inverting gain mode, so that the demodulation circuit can be simplified and the size thereof can be decreased, thus enabling the demodulation circuit to be implemented when a multi-channel signal is processed or circuit space is limited, and greatly reducing production costs and power consumption.

In order to accomplish the above object, the present invention provides a signal demodulation circuit, comprising an inverting amplifying circuit having an operational amplifier with a disable function, and a low pass filter circuit electrically connected to an output terminal of the inverting amplifying circuit to output a signal wave.

Preferably, the low pass filter circuit may comprise an RC integrator having a resistor and a capacitor. Preferably, the resistor of the RC integrator may have a resistance value adjusted to cause a sum of current flowing into the capacitor in an enable mode of the operational amplifier with a disable function and current flowing into the capacitor in a disable mode of the operational amplifier to be "0".

According to the above construction, the demodulation circuit obtains an output signal by causing the inverting amplifying circuit to have a non-inverting state only in a disable mode while inverting-amplifying an amplitude-modulated signal, and allows only a low frequency component of the output signal to pass therethrough, thus demodulating the modulated signal into a desired signal.

BRIEF DESCRIPTION OF THE DRAWINGS

     FIG. 1 is a circuit diagram of a demodulation circuit according to a first embodiment of the present invention;
     FIG. 2 is a circuit diagram of a demodulation circuit according to a second embodiment of the present invention;
     FIG. 3 is a graph showing the output of an operational amplifier when a sine wave of 20 KHz is applied to the demodulation circuit of FIG. 2 and the disable mode of the operational amplifier is switched using a synchronized square wave (R1 = R2 = 500, R3 = 10K, R5 = 50);

FIG. 4 is a graph showing the output of the operational amplifier when a sine wave of 20 KHz, which is amplitude- modulated at a frequency of 2 KHz, is applied to the demodulation circuit of FIG. 2 and the disable mode of the operational amplifier is switched using a square wave synchronized at a frequency of 20 KHz (R1 = R2 = 500, R3 = 10K, R5 = 50, C= 10nF); and

FIG. 5 is a graph showing the output of the operational amplifier when a sine wave of 20 KHz, which is amplitude- modulated at a frequency of 500 Hz, is applied to the demodulation circuit of FIG. 2 and the disable mode of the operational amplifier is switched using a square wave synchronized at a frequency of 20 KHz (R1 = R2 = 500, R3 = 10K, R5 = 50, C = 10nF).

## DESCRIPTION OF THE PREFERRED EMBODIMENTS

Hereinafter, embodiments of the present invention will be described in detail with reference to the attached drawings.

A demodulation circuit according to a first embodiment of the present invention includes an inverting amplifying circuit that includes an operational amplifier, having a disable function, and resistors, having a certain relation therebetween, and a RC integrator circuit connected to the inverting amplifying circuit.

Operational amplifier includes two operating mode that one is the able mode and the other is the disable mode. The former is to operate general amplification function, the latter is not to operate general amplification with power cutoff. The operational amplifier having disable mode function can control operation mode, which is either able mode or disable-mode.

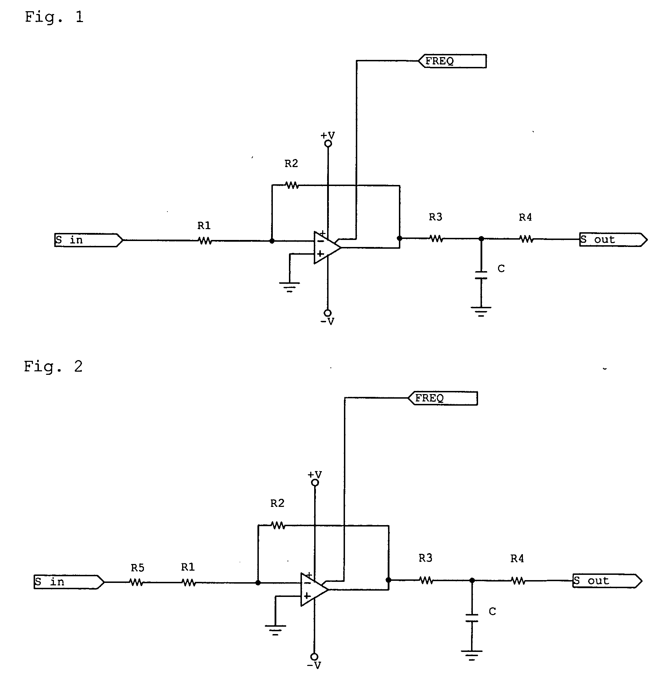

In Fig. 1, The signal demodulation circuit of the invention is shown.

Referring Fig. 1, The signal demodulation circuit of the invention includes inverting amplifying circuit and a RC integrator circuit connected to output of the inverting amplifying circuit.

The inverting amplifying circuit consists of operational amplifier and two resister, which is the input resistor R1 and the feedback resistor R2. The input resistor R1 and output resistor R2 is connecting to the operational amplifier to be operated as inverting amplifier in able mode. The input resistor R1 is connecting inverting input part of operational amplifier in series, the feedback resistor R2 is connecting to between inverting input part and output part with consisting inverting amplifying circuit

The RC integrator circuit is filtering low frequency signal. The RC integrator circuit includes an electric capacitor C and resistor R3. The electric capacitor C is connected to the resistor R3 in series. The resistor R3 is connected to output of the inverting amplifier circuit. The current, which is come from inverting amplifying circuit and go through resistor R3, flows and charge in capacitor C.

Referring to FIG. 1, the demodulation circuit according to the first embodiment of the present invention includes an inverting circuit having an amplification gain of - R2/R1. From the standpoint of a capacitor C, the inverting circuit is implemented with a circuit having an output resistor R3.

The disabling operational amplifier is characterized in that input/output thereof are changed to an open state (a high impedance state) in a disable mode. In the disable mode, Operational amplifier seems to be no existence because of a stage of input and output become open circuit mode, and becomes a circuit simply having a resistor corresponding to (R1+R2+R3) from the standpoint of the capacitor C.

The demodulation circuit detects output signal having special frequency among input signal. The output signal value is not '0'. Output signal is the voltage formed in both end node of the capacitor C and the voltage is changed as quantity of electric charge to flow into the capacitor C.

Defining the voltage formed in both end node of the capacitor C as Vc, A current to flow into the capacitor C is defined as $[-Sin\frac{R2}{R1} - Vc]\frac{1}{R3}$ in able mode because of operational amplifier act as inverting amplifier, and as $[Sin - Vc]\frac{1}{R1+R2+R3}$ in disable mode. The current consist of two factor. One is input signal $S_{in}$, the other is voltage formed in both end node of the capacitor C.

Generally, resistor value of low frequency filter circuit is relatively larger than that of operational amplifier. $-\frac{Vc}{R1+R2+R3}$ and $-\frac{Vc}{R3}$ which is factor of voltage formed in both end node of the capacitor C among the current to flow into capacitor C is almost same value because resistor value of R3 is relatively larger than summation value R1+R2 of input resistor R1 and output resistor R2.

Current by Input signal $S_{in}$ among the current which is flow into capacitor C has different direction in able mode and disable mode. Accordingly, the charge is accumulated with different direction in able mode and disable mode, and the voltage formed in both end node of the capacitor C has opposition sign in each mode, which is able mode and disable mode.

In the signal demodulation circuit, If operational amplifier has same time in able mode and disable mode, voltage formed in both end node of the capacitor C has same voltage with different sign in able mode and disable mode. Therefore, current by the voltage formed in both end node of the capacitor C is not contributed to output signal, and a current of $-S_{in} \dfrac{R2}{R1} \dfrac{1}{R3}$ is assumed to flows into the capacitor(c) in an enable mode, and a current of $S_{in} \dfrac{1}{R1 + R2 + R3}$ is assumed to flows into the capacitor in a disable mode.

Current by Input signal $S_{in}$ among the current which is flow into capacitor C has different direction in able mode and disablemode. If the amplifier is change by periods from able mode to disable mode, accumulated charge quantity is offset with current by input signal flowing.

If duration of an enable mode and duration of a disable mode of the operational amplifier is same with each other, and if input resistor R1, feedback resistor R2 and the resistor R3 of the RC integrator have resistance values respectively so that magnitude of current flowing into the capacitor C in an enable mode and in a disable mode is same with each other, then the components not having a frequency that is same with the special frequency in the input signal do not affect the output signal. It is because the electric charge cumulated in an enable mode and the electric charge cumulated in a disable mode by the current by the components offset each other. The special frequency is the frequency that state of the operational amplifier changes between an enable mode and a disable mode cyclically with.

In the demodulation circuit, state of the operational amplifier changes between an enable mode and a disable mode in accordance with a power input signal for the operational amplifier. It is preferred that duration of an enable mode and duration of a disable mode of the operational amplifier is same with each other. State of the operational amplifier changes cyclically in accordance with a power input signal in the shape of a square wave having special frequency.

Below, it is shown finding out resistance values of the input resistor R1, the feedback resistor R2, and the resistor R3 of the RC integrator that make a sum of current by the input signal Sin in an enable mode of the operational amplifier and current by input signal Sin in a disable mode of the operational amplifier "0" so that electric charge cumulated by the current by the input signal in an enable mode and in a disable mode offset each other. Although the input signal Sin contains components having various frequencies, it is considered as a constant for calculative convenience because components not having the special frequency do not affect the output signal.

If the sum of two currents becomes 0 when $S_{in}$ is a constant, the demodulation circuit is completed, so that the rate of resistances can be adjusted to satisfy the

relationship $\dfrac{1}{R1 + R2 + R3} = \dfrac{R2}{R1 \cdot R3}$. If R2/R1 = x and R3/R1 = y to simplify calculations, x and y, satisfying $x^2 +(1+y)x-y = 0$, can be detected from an equation $\dfrac{1}{1 + x + y} = \dfrac{x}{y}$ or $y = x(1+x+y) = x^2 + (1+y)x$. In this case, more simply, if y = 1, $x = \sqrt{5}$ - 2 = 0.236... is obtained. Therefore, if R2 = 0.236R1, and R3 = R1, the demodulation circuit can be completed.

Meanwhile, if a resistor array is used in a multi-channel mode, the manufacture of a circuit is generally further simplified. In the resistor array, since the values of resistors are the same, the circuit can be simplified if the input resistor R1 and the feedback resistor R2 of the inverting amplifying circuit have same resistance value with each other(R1 = R2) in the circuit of FIG. 1. However, it is difficult to obtain a suitable y value using the above method. One method of solving the difficulty is to add a resistor at an input terminal. Actually, since $S_{in}$ can have an output resistor, this model becomes more realistic. This model can be embodied through the circuit of FIG. 2, showing a demodulation circuit according to a second embodiment of the present invention.

In FIG. 2, if the output resistor of Sin is R5(output resistor of input signal), resistance values need to satisfy the condition $\dfrac{1}{R5 + R1 + R2 + R3} = \dfrac{R2}{(R5 + R1) \cdot R3}$ so as to cause the sum of currents flowing into the capacitor (C) in both the enable mode and the disable mode of the operational amplifier to be 0. In the above equation, if R1 = R2, as intended, and R5/R1 = x and R3/R1 = y, to simplify calculations, $\dfrac{1}{x + y + 2} = \dfrac{1}{(x+1) \cdot y}$ may be obtained, so that only $y = \dfrac{2}{x} + 1$ needs to be satisfied in $(x+1)y=x+y+2$ or $x(y-1)=2$. In this case, if the input resistor R1, the feedback resistor R2 of the inverting amplifying circuit and the output resistor R5 of input signal have same resistance value with each another(R1 = R2 = R5), the resistor R3 of the RC integrator has a resistance value three times as high as that of the input resistor R1 of the inverting amplifying circuit(R3 = R1). Preferably, the resistor R3 of the RC integrator has a resistance value higher than that of the input resistor R1 of the inverting amplifying circuit, more preferably the resistance value of resistor R3 of the RC integrator is twice as high as or more than that of the input resistor R1.

In performing low pass filtering, it is preferred to prevent great change in value of voltage formed in both end node of the capacitor C, the output signal, by increasing time constant the product of capacitance value of capacitor and resistance value of resistor. However, the capacitance value of the capacitor C is generally limited, so that low pass filtering is more efficiently performed when using a resistor R3 having high resistance. Therefore, if the input resistor R1 of the inverting amplifying circuit does not have high resistance, it is efficient to use other combinations. For example, in order to perform design to satisfy R5<R1<R3, x << y is satisfied in the above equation, so that only R5 = 50, R1 =500 and R3 = 10K need to be satisfied to obtain xy = 2.

Preferably, the resistor of the RC integrator has a resistance value ten times as high as or more than that of the input resistor and the feedback resistor of the inverting amplifying circuit.

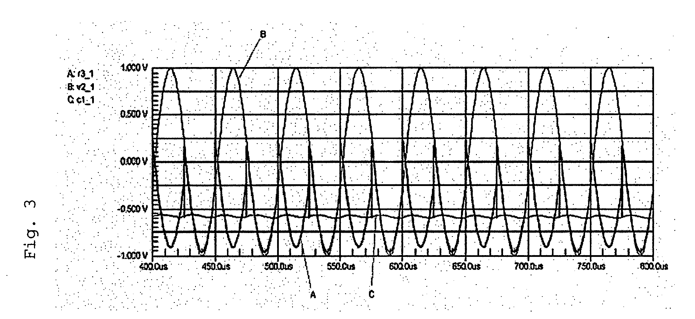

FIG. 3 illustrates output results of the circuit of FIG. 2. Line B denotes an input signal having a frequency of 20KHz, line A denotes a demodulated signal having a frequency of 40KHz (signal at the input terminal of R3), and line C denotes a waveform having a Direct Current (DC) value proportional to the magnitude of the component of the input signal having a frequency of 20KHz because a component having a frequency of 40KHz is attenuated by the RC filter.

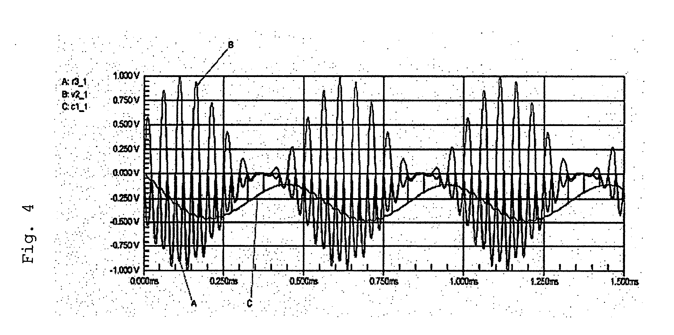

FIG. 4 illustrates the signal of the output terminal of the operational amplifier and a signal obtained after RC filtering, when an amplitude-modulated signal is demodulated. Line C denotes a signal having a frequency of 2KHz, which is the frequency of the amplitude-modulated signal, and having a magnitude proportional to a degree of amplitude modulation. However, it can be seen that, since 2KHz, which is the amplitude modulation frequency, is not negligibly lower than 10KHz, which is the frequency of a resonance point of an RC circuit, a phase difference is generated.

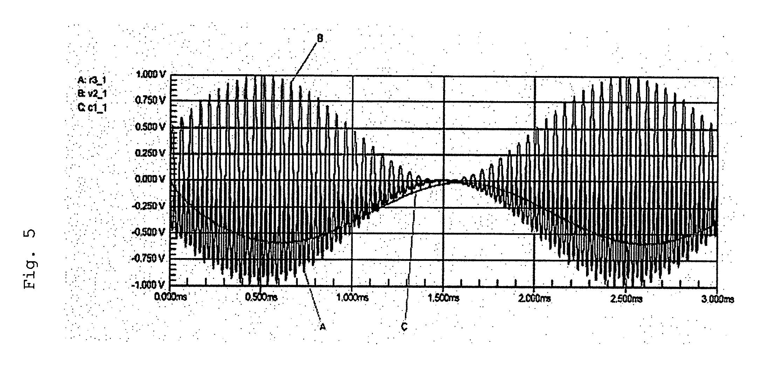

FIG. 5 shows an example in which an amplitude modulation frequency is low. In FIG. 5, it can be seen that, when amplitude modulation is performed at a frequency of 500 Hz, a phase shift is further decreased.

Accordingly, the present invention provides a signal demodulation circuit, which has a simplified construction, thus reducing the size of the circuit, enabling a demodulation circuit to be implemented when a multi-channel signal is processed or when circuit space is limited, and greatly reducing production costs and power consumption.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A signal demodulation circuit, comprising:

   an inverting amplifying circuit having an operational amplifier with a disable function; and
   a low pass filter circuit electrically connected to an output terminal of the inverting amplifying circuit to output a signal wave.

2. The signal demodulation circuit according to claim 1, wherein the inverting amplifying circuit comprises the operational amplifier with a disable function, and an input resistor one end thereof connected to inverting input terminal of the operational amplifier and a feedback resistor connected between inverting input terminal and output terminal of the operational amplifier.

3. The signal demodulation circuit according to claim 2, wherein the input resistor and the feedback resistor have the same resistance value.

4. The signal demodulation circuit according to claim 2, wherein the low pass filter circuit comprises an RC integrator having a resistor and a capacitor.

5. The signal demodulation circuit according to claim 4, wherein the resistor of the RC integrator has a resistance value adjusted with respect to resistance values of the input resistor and the feedback resistor of the inverting amplifying circuit so that a sum of current flowing into the capacitor in an enable mode of the operational amplifier with a disable function and current flowing into the capacitor in a disable mode of the operational amplifier is "0".

6. The signal demodulation circuit according to claim 4, wherein the resistor of the RC integrator has a resistance value twice as high as or more than that of the input resistor and the feedback resistor of the inverting amplifying circuit.

7. The signal demodulation circuit according to claim 4, wherein the resistor of the RC integrator has a resistance value ten times as high as or more than that of the input resistor and the feedback resistor of the inverting amplifying circuit.

8. The signal demodulation circuit according to claim 2, wherein the input resistor and the feedback resistor of the inverting amplifying circuit belong to the same resistor array.

9. The signal demodulation circuit according to claim 2, more comprising output resistor of input signal connected in series to input terminal of the inverting amplifying circuit.

**10.** The signal demodulation circuit according to claim 9, wherein the output resistor of input signal has a resistance value lower than that of the input resistor and feedback resistor of the inverting amplifying circuit.

**11.** The signal demodulation circuit according to claim 1, wherein state of the operational amplifier changes from one to the other cyclically between an enable mode and a disable mode.

**12.** The signal demodulation circuit according to claim 11, wherein duration of an enable mode and duration of a disable mode of the operational amplifier is same with each other.

**13.** The signal demodulation circuit according to claim 11, state of the operational amplifier changes in accordance with a power input signal for the operational amplifier in the shape of a square wave.

Fig. 1

Fig. 2

Fig. 3

Fig. 4

Fig. 5

European Patent
Office

**EUROPEAN SEARCH REPORT**

Application Number

EP 05 01 9999

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PATENT ABSTRACTS OF JAPAN vol. 006, no. 251 (E-147), 10 December 1982 (1982-12-10) & JP 57 150206 A (TOKYO SHIBAURA DENKI KK), 17 September 1982 (1982-09-17) * abstract * | 1-13 | H03D1/18 |
| A | US 2002/090026 A1 (ASHLEY FRANCIS R) 11 July 2002 (2002-07-11) * paragraph [0021] - paragraph [0034]; figure 2 * | 1-13 | |
| A | CIUBOTARU A: "METER INDICATES 455-KHZ CARRIER LEVEL" EDN ELECTRICAL DESIGN NEWS, REED BUSINESS INFORMATION, HIGHLANDS RANCH, CO, US, vol. 37, no. 22, 29 October 1992 (1992-10-29), page 142, XP000320855 ISSN: 0012-7515 * the whole document * | 1-13 | |
| | | | **TECHNICAL FIELDS SEARCHED (IPC)** |
| A | US 5 796 303 A (VINN ET AL) 18 August 1998 (1998-08-18) * column 3, line 28 - column 4, line 13; figure 3 * | 1-13 | H03D |

The present search report has been drawn up for all claims

| Place of search | Date of completion of the search | Examiner |
|---|---|---|
| Munich | 11 January 2006 | Ratajski, A |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 05 01 9999

This annex lists the patent family members relating to the patent documents cited in the above-mentioned European search report.
The members are as contained in the European Patent Office EDP file on
The European Patent Office is in no way liable for these particulars which are merely given for the purpose of information.

11-01-2006

| Patent document cited in search report | | Publication date | Patent family member(s) | | Publication date |
|---|---|---|---|---|---|
| JP 57150206 | A | 17-09-1982 | JP | 1047928 B | 17-10-1989 |
| | | | JP | 1565476 C | 25-06-1990 |
| US 2002090026 | A1 | 11-07-2002 | US | 6385234 B1 | 07-05-2002 |
| US 5796303 | A | 18-08-1998 | NONE | | |

EPO FORM P0459

For more details about this annex : see Official Journal of the European Patent Office, No. 12/82